# EUROPEAN PATENT APPLICATION

(11) **EP 1 746 666 A2**
(43) Date of publication of application: **24.01.2007**
(21) Application number: 06253763.4
(22) Date of filing: 19.07.2006
(51) Int. Cl.: H01L 33/00, G02F 1/13357

(54) **Side view led package and backlight unit using the same**

(30) Priority: 19.07.2005 KR 20050065231
(71) Applicant: Samsung Electro-Mechanics Co., Ltd., Suwon, Kyungki-do (KR)
(72) Inventor: Song, Young Jae, A-304 Sungdong Apt., Kyungki-do (KR); Roh, Jae Ky, 337-1604 Byucksan Apt., Kyungki-do (KR); Hong, Seong Jae, 107-204 Hyundai Home Town, Kyungki-do (KR); Baek, Jong Hwan, 102-905 Woosung Apt., Seoul (KR); Kim, Chang Wook, 118-2103 Daelim Apt., Kyungki-do (KR)
(74) Representative: Johnstone, Helen Margaret

(57) **Abstract**

The invention relates to a side-emission type LED package capable of minimizing light loss to achieve high luminance and to a backlight unit using the same. The LED package includes a lead frame with an electrode formed thereon and a light emitting diode chip disposed on the lead frame. The LED package further includes a body made of molded material surrounding the light emitting diode chip disposed on the lead frame, the body having an asymmetrical shape; and a reflecting part extended from a side of the body to downwardly reflect light emitted from the light emitting diode chip. The reflecting part is extended from the upper edge of the body housing the LED chip to effectively block light from leaking outside, thereby achieving high-luminance emission.

## Description

### CLAIM OF PRIORITY

This application claims the benefit of Korean Patent Application No. 2005-65231 filed on July 19, 2005, in the Korean Intellectual Property Office, the disclosure of which is incorporated herein by reference.

### BACKGROUND OF THE INVENTION

### Field of the Invention

The present invention relates to a side view light emitting diode (LED) package capable of minimizing light loss to achieve high-luminance light emission, and to a backlight unit using the same. More particularly, the invention relates to a side view LED package having a reflecting part extended from an upper edge of a body housing an LED chip therein, effectively preventing leakage of light, thereby achieving high-luminance light emission, and to a backlight unit using the same.

### Description of the Related Art

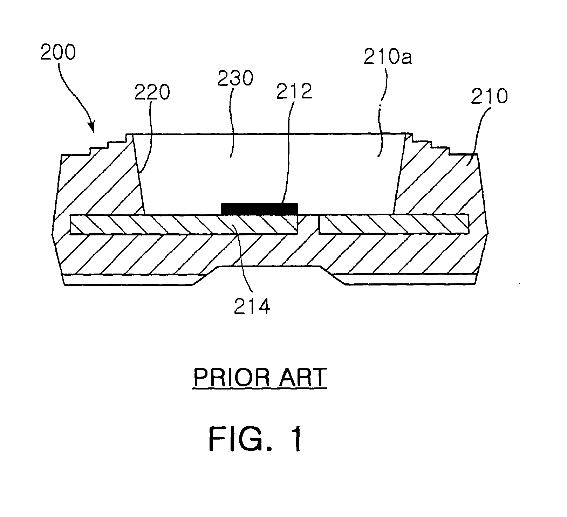

A light emitting diode (LED) package is increasingly used as a light source for a Liquid Crystal Display backlight unit (LCD BLU). As shown in FIG. 1, the high power LED package 200 used for the LED BLU includes an LED chip 212 and lead frames 214 disposed in an inner space 210a of a body 210 made of a molded material, a reflective film 220 formed on surfaces of the inner space 210a of the molded body 210, and transparent resin 230 filling the inner space 210a.

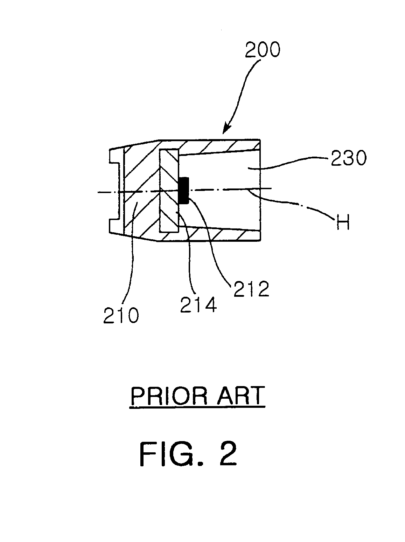

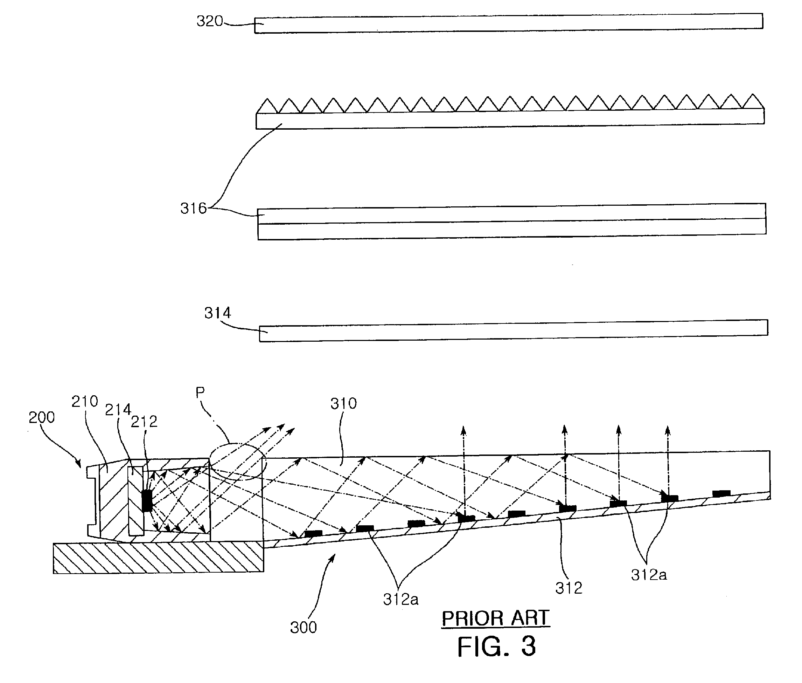

In addition, as shown in FIG. 2, the body 210 having the LED chip 212 therein has a vertically symmetrical cross-section. As shown in FIG. 3, when applied to a backlight unit 300, this conventional LED package 200 allows delivery of only about 20% to 30% of total light source of the LED chip 212 to a light guide panel 310. The delivered light is transformed from a point light source to a surface light source via the light guide panel 310, eventually reaching a display panel 320. Thus, about 70% to 80% of light leaks to the outside.

FIG. 3 illustrates the backlight unit 300 adopting the conventional LED package 200.

The Liquid Crystal Display (LCD) applied to such a backlight 300 has no light source of its own, thus using the backlight unit 300 as an illumination device. The backlight unit 100 illuminates the LCD from the back side.

At one side of the above described conventional backlight unit 300, an LED package 200 is disposed while at the other side thereof, a light guide panel 310, a reflective plate 312, a pair of prism sheets 316 and a display panel 320 are disposed.

Light incident onto the light guide panel 310 from the LED package 200 is reflected toward the display panel 320 by the reflective plate 312, thereby backlighting the LCD.

More specifically, the conventional LED package 200 includes an LED chip 212, a lead frame 214 for providing power to the LED chip 212 mounted thereon, a body 210 made of molded material for housing the LED chip 212 and the lead frame 214 therein, and a transparent resin 230 filled in an inner space 210a of the body 210.

As shown in FIG. 3, light emitted from the LED chip 212 enters the light guide panel 310 and moves around therein. When the light impinges on dot patterns 312a formed on the reflective plate 312, it is reflected upward to pass through the diffusion plate 314 and the prism sheets 316, eventually reaching the display panel 320.

In this process, since the LED package 200 is disposed in a predetermined distance from the light guide panel 310 due to their structural relationship, some portion of light leaks to the outside as light exits the LED package 200 to enter the light guide panel 310, thereby decreasing the amount of light. As light exits from the LED package 200 to enter the light guide panel 310, the light is scattered upward or downward by the reflective film 220 (see FIG. 1) formed in the body 210. This scattered light should be reflected by the reflective plate 312 to propagate toward the display panel 320 in order to effectively utilize light as a light source for the LCD. Nonetheless, a portion of light P exiting from the LED package 200 in upward direction cannot reach the reflective plate 312.

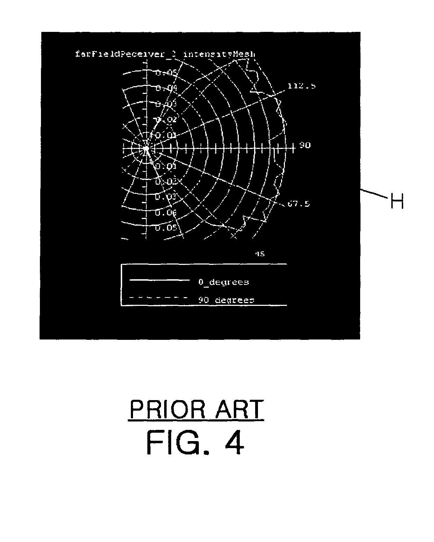

Therefore, the conventional LED package 200 does not allow delivery of about 70% to 80% of light to the light guide panel 310, and thus a considerable part of light leaks to the outside. Examining beam angles of light exiting from the LED package 200 toward the light guide panel 310, as shown in FIG. 4, they are substantially identical in upper and lower ranges about a horizontal center line H. As shown in FIG. 2, because the body 210 of the LED package 200 is symmetrical about the horizontal center line H, only about 20% to 30% of light exiting from the LED package 200 toward the light guide panel 310 actually enters the light guide panel 310. The rest 70% to 80% of light exits from the LED package 200 in upward direction toward the space or area above the light guide panel 310, thus leaking to the outside.

Therefore, the conventional LED package 200 and the backlight 300 using the same hardly achieve high luminance due to a great amount of light loss.

### SUMMARY OF THE INVENTION

The present invention has been made to solve the foregoing problems of the prior art and therefore an object of certain embodiments of the present invention is to provide a side view LED package capable of providing light from an LED chip into a light guide panel with minimum loss of light generated from the LED chip, thereby achieving high luminance, and to a backlight unit using the same.

Another object of certain embodiments of the invention is to provide a side view LED package which increases the amount of light in a downward beam angle toward a light guide panel to direct a greater amount of light to a reflective plate of the light guide panel and converge a maximum amount of light to a light diffuser of the light guide panel, thereby illuminating a liquid crystal display with high luminance, and to a backlight unit using the same.

According to an aspect of the invention for realizing the object, there is provided a light emitting diode package for emitting light sideward from a light emitting diode chip, including: a lead frame with an electrode formed thereon; a light emitting diode chip disposed on the lead frame; a body made of molded material surrounding the light emitting diode chip disposed on the lead frame, the body having an asymmetrical shape; and a reflecting part extended from a side of the body to downwardly reflect light emitted from the light emitting diode chip.

According to a certain embodiment of the invention, the reflecting part is protruded from an upper edge of the body that forms an inner space in the light emitting diode package to be extended beyond a lower edge of the body.

In addition, the reflecting part comprises a reflective film formed thereon.

Moreover, the reflecting part is extended from the entire upper edge of the body that forms the inner space to completely block light emitted from the inner space from leaking upward.

According to another aspect of the invention for realizing the object, there is provided a backlight unit for illuminating a liquid Crystal Display using light from a light emitting diode chip, including: a light emitting diode package including a light emitting diode chip disposed therein, a body surrounding the light emitting diode chip, the body having a reflecting part for downwardly reflecting light emitted from the light emitting diode chip; a light guide panel for guiding light from the light emitting diode package; and a reflective plate for reflecting light inside the light guide panel toward a liquid crystal display.

According to the invention, the backlight unit further includes a diffusion plate, a prism sheet and a display panel stacked above the light guide panel.

### BRIEF DESCRIPTION OF THE DRAWINGS

The above and other objects, features and other advantages of the present invention will be more clearly understood from the following detailed description taken in conjunction with the accompanying drawings, in which:

FIG. 1 is a sectional view illustrating a light emitting diode (LED) package according to the prior art;

FIG. 2 is a side sectional view illustrating the LED package according to the prior art;

FIG. 3 is an exploded view illustrating the operation of a backlight unit using the LED package according to the prior art;

FIG. 4 is a graph illustrating the characteristics of beam angles of light emitted from the LED package according to the prior art;

FIG. 5 is a sectional view illustrating an LED package according to the present invention;

FIG. 6 is a side sectional view illustrating the LED package according to the present invention;

FIG. 7 is an exploded view illustrating the operation of a backlight unit using the LED package according to the present invention; and

FIG. 8 is a graph illustrating the characteristics of beam angles of light emitted from the LED package according to the present invention.

### DETAILED DESCRIPTION OF THE PREFERRED EMBODIMENT

Preferred embodiments of the present invention will now be described in detail with reference to the accompanying drawings.

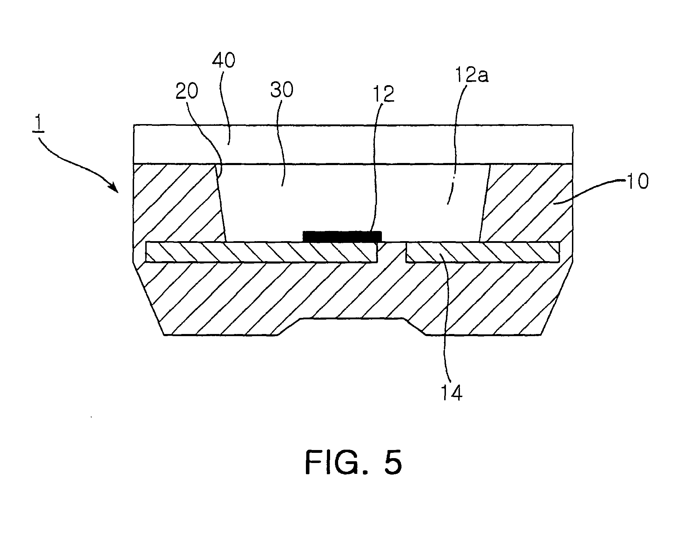

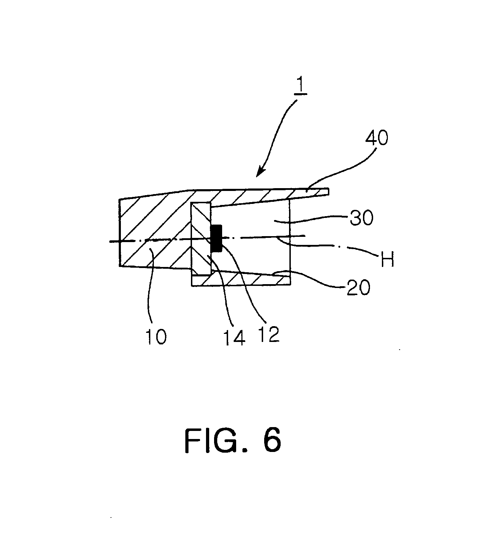

As shown in FIGS. 5 and 6, the side view light emitting diode (LED) package 1 according to the present invention includes an LED chip 12 disposed on lead frames 14 each with an electrode formed thereon and a body 10 surrounding the LED chip 12 on one of the lead frames 14. The body 10 is made of molded material and has an asymmetrical shape.

The body 10 has an upper edge extended toward a light guide panel 110, which will be described later, beyond a lower edge, thereby forming a reflecting part 40.

That is, the reflecting part 40 is protruded from the upper edge of the body 10 that forms an inner space 12a and extended toward the light guide panel 110 beyond the lower edge of the body 10. The reflecting part 10 can be integrally molded with the body 10.

The reflecting part 40 is extended from an entire length of the upper edge of the body 10 that forms the inner space 12a of the LED package 1 so that light exiting from the inner space 12a is completely blocked from leaking upward.

In addition, a reflective film 20 is formed on inner surfaces of the body 10 that define lateral perimeters of the inner space 12a where the LED chips 12 are mounted on the lead frame 14.

The reflective film 20 is a film made of highly reflective material. The suitable material includes metal and reflective paint.

The reflective film 20 can be made of metal having high reflectivity of at least 90%, for example, at least one selected from a group consisting of Ag, Al, Au, Cu, Pd, Pt, Rd and alloys thereof. It is preferable that the reflective film 20 has a thickness of at least 1, 0000 , or more preferably, from 3,000□ to 1µm. Preferably, the reflective film 20 can be formed by deposition. The deposition methods include sputtering and electron beam processing.

To conduct sputtering, sputtering gas is injected into a vacuum chamber (not shown) and is collided to a material desired to form a reflective film 20 thereon, thereby generating plasma, which in turn is coated on the inner surface of the body 10.

Alternatively, a reflective paint can be applied rather than using such highly reflective metal to form the reflective film 20. The suitable reflective paint may contain at least one reflective material having 80% to 90% of reflectivity, selected from a group consisting of TiO₂, ZnO and CaCo₃.

Such reflective material can be diluted in a solvent with an adhesive and applied on a preset portion of the body 10 of the package 1 to form the reflective film 20. At this point, the reflective material can be diluted at 10wt% to 50wt% of density, and preferably at 20wt% to 30wt% of density. The reflective material can be applied using a spray, roller, etc.

The reflective film 20 is identically applied to the reflecting part 40 to downwardly reflect light from the LED chip 12.

In addition, the invention provides a backlight unit 100 using the LED package 1 as a light source. The LED package 1 includes an LED chip 12 disposed therein and a reflecting part 40 extended from a body 10 that surrounds the LED chip 12.

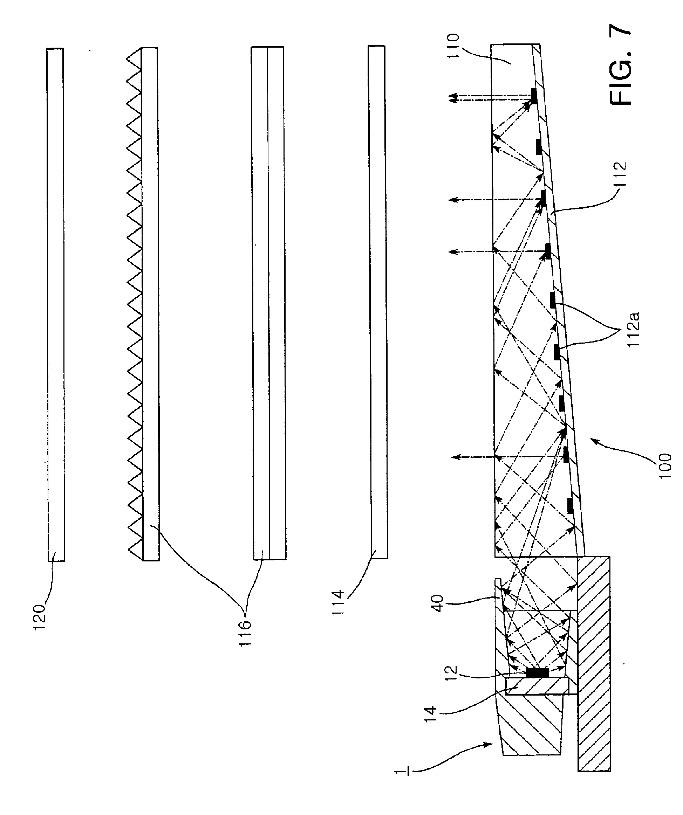

As shown in FIG. 7, the LED package 1 is disposed at one side of the backlight unit 100 while a light guide panel 110 is disposed at the other side thereof for guiding light from the LED package. The light guide panel 110 includes a reflective plate 112 formed on a lower part thereof for reflecting light in the light guide panel 110 toward the entire surface of a Liquid Crystal Display (LCD).

In addition, the backlight unit 100 according to the present invention may include a diffusion plate 114, a pair of prism sheets 116 and a display panel 120 above the light guide panel 110.

Therefore, in the backlight unit 100 according to the present invention, light incident from the LED package 1 onto the light guide panel 110 is delivered to the display panel 120 to backlight the LCD. That is, as light generated from the LED chip 12 enters the light guide panel 110, light does not leak to the outside, i.e., in upward direction, and in turn, most of the light is incident onto the light guide panel 110.

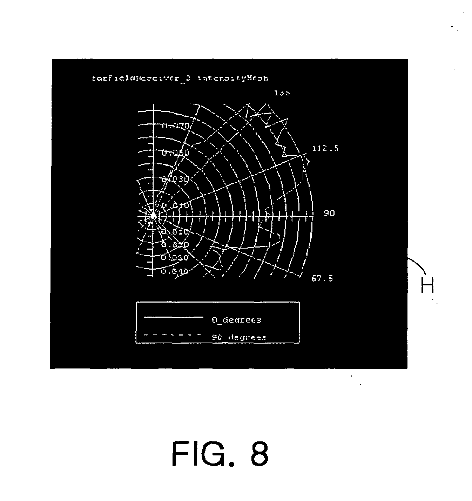

As shown in FIG. 8, examining beam angles of light exiting toward the light guide panel 110, light is converged toward a lower area with respect to a horizontal center H of the LED package 1. That is, as shown in FIG. 6, the body 10 of the LED package 1 has an asymmetrical shape with respect to the horizontal center H with the protruded upper edge and the shorter lower edge. Thus, most of the light exiting from the LED package 1 toward the light guide panel 110 is directed downward to the reflective plate 112, thereby being reflected toward the display panel 120.

According to the present invention with the above described configuration, the LED package 1 and the backlight unit 100 using the same have the reflecting part 40 extended from the upper edge of the body 10, which is made of molded material and houses the LED chip 12. The reflecting part 40 is extended from the upper edge of the body 10 that forms the inner space 12a, beyond the lower edge of the body 10. Thus, light emitted from the LED chip 12 enters the light guide panel 110 without leaking to the outside, i.e., in upward direction. Therefore, most of light enters the light guide panel 110.

While moving around in the light guide panel 110, if light collides to dot patterns 112a of the reflective plate 112 on the lower part of the light guide panel 110, it is reflected upward to pass through the diffusion plate 112 and the prism sheets 116 above the light guide panel 110, eventually exiting out of the display panel 120, thereby backlighting the LCD with high luminance.

Therefore, according to the present invention, most of light exits from the LED package 1 toward a lower part of the light guide panel 110, thus minimizing light loss and thereby providing the high-luminance and high-output LED package 1 and the backlight unit 100 using the same.

According to the present invention set forth above, light emitted from an LED chip is provided into a light guide panel with minimum light loss, thereby achieving high luminance.

In addition, with the increased downward beam angle where light exiting from the LED package can be introduced into the light guide panel, a great amount of light is directed toward a reflective plate and a maximum amount of light is converged to the diffusion plate of the light guide panel, thereby achieving high luminance.

While the present invention has been shown and described in connection with the preferred embodiments, it will be apparent to those skilled in the art that modifications and variations can be made without departing from the scope of the invention.

## Claims

1. A light emitting diode package for emitting light sideward from a light emitting diode chip, comprising:
a lead frame with an electrode formed thereon;
a light emitting diode chip disposed on the lead frame;
a body made of molded material surrounding the light emitting diode chip disposed on the lead frame, the body having an asymmetrical shape; and
a reflecting part extended from a side of the body to downwardly reflect light emitted from the light emitting diode chip.

2. The light emitting diode package according to claim 1, wherein the reflecting part is protruded from an upper edge of the body that forms an inner space in the light emitting diode package to be extended beyond a lower edge of the body.

3. The light emitting diode package according to claim 2, wherein the reflecting part comprises a reflective film formed thereon.

4. The light emitting diode package according to claim 1, wherein the reflecting part is extended from the entire upper edge of the body that forms the inner space to completely block light emitted from the inner space from leaking upward.

5. A backlight unit for illuminating a liquid Crystal Display using light from a light emitting diode chip, comprising:
a light emitting diode package including a light emitting diode chip disposed therein, a body surrounding the light emitting diode chip, the body having a reflecting part for downwardly reflecting light emitted from the light emitting diode chip;
a light guide panel for guiding light from the light emitting diode package; and
a reflective plate for reflecting light inside the light guide panel toward a liquid crystal display.

6. The backlight unit according to claim 5, further comprising a diffusion plate, a prism sheet and a display panel stacked above the light guide panel.
